# EUROPEAN PATENT SPECIFICATION

(11) **EP 4 596 653 B1**
(45) Date of publication and mention of the grant of the patent: **27.05.2026**
(21) Application number: 23941143.2
(22) Date of filing: 30.06.2023
(51) Int. Cl.: C09K 11/02, C09K 11/61, C09K 11/66, C09K 11/67, G02F 1/1335, H10H 20/851

(54) **ANTI-DETERIORATION RED PHOSPHOR, AND PREPARATION METHOD AND APPLICATION THEREOF**
DETERIORATIONSBESTÄNDIGER ROTER LEUCHTSTOFF SOWIE HERSTELLUNGSVERFAHREN UND ANWENDUNG DAVON
PHOSPHORE ROUGE ANTI-DÉTÉRIORATION, PROCÉDÉ DE PRÉPARATION ET APPLICATION DE CELUI-CI

(30) Priority: 16.06.2023 CN 202310724565
(43) Date of publication of application: 06.08.2025
(73) Proprietor: JIANGSU BREE OPTRONICS CO., LTD, Nanjing, Jiangsu 211103 (CN); JIANGSU CHERRITY OPTRONICS CO., LTD, Nanjing, Jiangsu 211103 (CN)
(72) Inventor: HE, Jinhua, Nanjing, Jiangsu 211103 (CN); LIANG, Chao, Nanjing, Jiangsu 211103 (CN); YAO, Leqi, Nanjing, Jiangsu 211103 (CN); ZHONG, Bo, Nanjing, Jiangsu 211103 (CN); WANG, Jing, Nanjing, Jiangsu 211103 (CN)
(74) Representative: Winter, Brandl - Partnerschaft mbB
(86) International application number: PCT/CN2023/104433
(87) International publication number: WO 2024/254911

(56) References cited:
- CN-A- 105 038 776
- CN-A- 107 057 702
- CN-A- 107 236 543
- CN-A- 111 471 456
- CN-A- 113 337 279
- JP-A- 2020 172 633
- US-A1- 2021 155 848

## Description

The present application claims priority to Chinese application No. 2023107245653 filed on June 25, 2023 and entitled "ANTI-DETERIORATION RED PHOSPHOR, AND PREPARATION METHOD AND APPLICATION THEREOF".

### FIELD

The present application relates to an anti-deterioration red phosphor, and a preparation method and an application thereof, and belongs to the technical field of phosphor materials technology.

### BACKGROUND

In LED lighting, usually, after being stirred with silica gel to disperse, the phosphor is spotted into the LED package bracket cup through spin glue. In application, the excitation light is emitted from the blue chip, and after being absorbed by the phosphor in the LED package, the emitted light of the phosphor is transmitted out through reflection, refraction, etc. The excitation light would cause the scattering of the phosphor when the excitation light irradiates to the surface of the phosphor, resulting in losing the luminous efficiency of some phosphors.

The red phosphor with high luminous efficiency would meet the following conditions: 1) the red phosphor with a particle size of about 459 nm has a strong absorption capability; 2) the red phosphor has narrow emission at about 630 nm; and 3) the red phosphor has small emission above 650 nm. The K₂SiF₆ : Mn⁴⁺ phosphor material has an emission spectrum consistent with those characteristics, and the CRI (color rendering index) is greater than 90, which makes its light efficiency have a significant advantage over the traditional red nitride phosphor. However, due to the surface hydrolysis of MnF₆²⁻ group, the moisture resistance of the fluoride phosphor is poor, which leads to deterioration of the performance of corresponding LED packaging devices in long-term service.

The related art proposes a tetravalent Mn doping fluoride phosphor constructed with a core-shell structure. It uses a reductive agent treatment agent to perform Mn⁴⁺ activation center failure treatment on the surface of the particle of the phosphor. After the treatment, in the particle of the phosphor, the closer the distance is to the shell from the inside to the outside, the lower Mn⁴⁺ content is. While the method enhances the moisture resistance of the phosphor to some degree, it would have a negative impact on the luminous efficiency of the phosphor.

### SUMMARY OF INVENTION

In view of the shortcomings of the related art, the present application provides an anti-deterioration red phosphor, and a preparation method and an application thereof, which adopts a core-shell structure and controls an activator concentration in the innermost layer of an inner core is the lowest and in the outermost layer of the inner core is the highest. At the same time, cooperating with the inner core of the phosphor coated with an outer shell with little or no activator content improves moisture resistance and anti-deterioration ability of the phosphor. Meanwhile, it is beneficial to maintain high luminous efficiency by cooperating with the inner core.

The present invention is defined in the appended claims. The first purpose of the present application is to provide an anti-deterioration red phosphor, and the technical solution used is as follows.

An anti-deterioration red phosphor, the core-shell structure includes an inner core and an outer shell, the inner core and the outer shell are independently selected from substances shown in a chemical formula I; the chemical formula I: A₂M₍₁₋ₓ₎F₆ : xMn⁴⁺; in the chemical formula I, the A includes at least one of Li, Na, K, Rb and Cs, and the M includes at least one of Si, Ge and Ti; wherein, an atom percentage of Mn⁴⁺ in an innermost layer of the inner core is a, and the atom percentage of Mn⁴⁺ in an outermost layer of the inner core is b, and b > a; and the atom percentage of Mn⁴⁺ in each place inside a particle of the inner core is x₁, and a value range of the x₁ is a≤x₁ ≤b; and the atom percentage of Mn⁴⁺ in the outer shell is x₂, and a value range of the x₂ is 0≤x₂ 0.1%. In the present application, the phosphor is granular, the innermost layer of the inner core refers to the central layer inside a particle of the phosphor, which is also a layer with the least atom percentage of Mn⁴⁺; and the outermost layer of the inner core refers to a layer with the largest atom percentage of Mn⁴⁺ in the phosphor. The outer shell refers to a part outside the outermost layer of the inner core in the phosphor, that is, the part without the outermost layer of the inner core from the outermost layer of the inner core to an outer surface of the phosphor. In the present application, by controlling the atom percentages of Mn⁴⁺ in the innermost layer of the inner core to be the lowest and the outermost layer of the inner core to be the highest, the activator concentration in the center of the inner core of the phosphor is reduced, which is beneficial to suppress the thermal quenching effect and improve the thermal stability. In addition, the concentration of the activator ion on the surface of the inner core is increased, therefore increasing a absorption rate of the phosphor to excitation light, and suppressing scattering effect, which is beneficial to improve the luminous efficiency of the corresponding LED device. By setting the outer shell with very little Mn⁴⁺ content to coat the inner core of the phosphor, contacting between a luminescent center and an external environment is avoided, and the moisture resistance and anti-deterioration ability of the phosphor are improved. At the same time, coordination with the inner core would not affect the luminous efficiency of the phosphor, which is advantageous for the phosphor to maintain a high luminous intensity during its long-term service.

Furthermore, a value range of x₂ in the outer shell is 0≤x₂≤0.05%, so as to further improve the moisture resistance and anti-deterioration ability of the particle of the phosphor.

Preferably, the x₁ is in an increasing trend from an inside to an outside in a radial direction of the inner core. In the present application, the x₁ is in the increasing trend from the inside to the outside in the radial direction, which means that a content of Mn⁴⁺ in the particle of the phosphor is in an increasing trend from the inside to the outside in the radial direction. That is to say, with a distance in the radial direction from the innermost layer as an abscissa and the content of Mn⁴⁺ as an ordinate, the correlation curve plotted shows an increasing trend. However, in two adjacent layers of the particle of the phosphor from the inside to the outside, the atom percentage of Mn⁴⁺ could increase, decrease, or remain unchanged. The relationship between the content of Mn⁴⁺ in the innermost layer and the outermost layer of the inner core of the phosphor is ensured by controlling the atom percentage of Mn⁴⁺ to increase from the inner to the outer in the radial direction of the inner core. Meanwhile, the content of Mn⁴⁺ in each place in the inner core is smoothly transitioned from the inside to the outside in the radial direction, which ensures the absorption efficiency of the inner core for the excitation light and is conducive for the improvement of the luminous efficiency of the particle of the phosphor.

Preferably, the increasing trend is that the x₁ increases linearly and uniformly from the inside to the outside in the radial direction of the inner core. Increasing linearly and uniformly in the present application means that the atom percentage of Mn⁴⁺ keeps a same linear growth trend from the inside to the outside in the radial direction of the inner core. In the present application, by controlling the atom percentage of Mn⁴⁺ in the inner core to maintain a linear uniform increase, the closer the particle of the phosphor is to the outermost layer of the inner core, the higher the concentration of Mn⁴⁺. In addition, the content of Mn⁴⁺ in the inner core is in a uniform growth distribution trend, enabling the phosphor could fully absorb the excitation light and enhancing its conversion efficiency of the phosphor, which is conducive to further improving the luminous efficiency of the phosphor.

Preferably, in the inner core, a value range of the a is 0≤a≤0.1%, and a value range of the b is 0.3%≤b≤5%. By controlling a range of the atom percentage of Mn⁴⁺ in the inner core, the present application regulates content distribution of Mn⁴⁺ from the innermost layer of the inner core to the outermost layer of the inner core, ensuring the activator concentration on the surface and inside of the inner core, which is beneficial to improve the absorption efficiency of the phosphor.

Preferably, in the inner core, 0.2%≤ (b-a) ≤5%, and further preferably 0.5%≤(b-a) ≤2%.

For example, the value range of the a is 0≤a≤0.01%, and the value range of the b is 0.5%≤b≤1.5%.

Preferably, in the inner core, a value of the a is 0 and a value of the b is 0.7%≤b≤1%. For example, in the inner core, the value of the a is 0, and the value of the b is 0.7%≤b≤0.85%.

Preferably, in the phosphor, b>x₂.

Preferably, in the phosphor, 0≤x₂/b≤1/10.

Preferably, an average particle size of the anti-deterioration red phosphor is 5-40 µm. For example, the average particle size of the anti-deterioration red phosphor is 25-40 µm.

Preferably, the average thickness of the outer shell is 0.1-2 µm. Adopting the above average thickness of the outer shell could enhance the moisture resistance and anti-deterioration ability of the phosphor, and avoid scattering of the excitation light, which is beneficial to promote the inner core to play full role of the light efficiency.

The second purpose of the present application is to provide a preparation method for the anti-deterioration red phosphor, and the technical solution used is as follows.

A preparation method for any one of the above anti-deterioration red phosphors, the preparation method includes following steps: (1) dissolving a salt of the A in a hydrofluoric acid solution, denoted as a base liquid A solution; (2) preparing a series of BX solutions with different concentrations of K₂MnF₆ by taking a series of the K₂MnF₆ and dissolving the series of the K₂MnF₆ in equal masses of H₂MF₆ solutions; and (3) adding the series of the BX solutions into the base liquid A solution in turn, controlling a concentration of the K₂MnF₆ in the BX solution added for a first time is the lowest, controlling the concentration of K₂MnF₆ in the BX solution added for a last time is the highest, obtaining an inner core mixed system to prepare the inner core, and adding the H₂MF₆ solution into the inner core mixed system to prepare the outer shell to obtain the anti-deterioration red phosphor; wherein, the salt of the A is selected from at least one of a fluoride, a hydrogen fluoride salt, a sulfate, a nitrate, a sulfuric acid hydrogen salt, a carbonate, and a bicarbonate of the A, and the A is selected from any one of Li, Na, K, Rb and Cs, and in the K₂MF₆, the M is selected from any one of Si, Ge and Ti. In the present application, K₂MnF₆ and H₂MF₆ solutions are used to prepare the series of the BX solutions with increasing concentrations of K₂MnF₆, and A₂MF₆:Mn⁴⁺ precipitates are prepared by an instantaneous reaction when the BX solution is mixed with the base liquid A solution. By controlling the concentrations of K₂MnF₆ of the BX solutions in the first addition and the last addition, the atom percentage of Mn⁴⁺ is the lowest in the innermost layer of the inner core and the highest in the outermost layer, which is beneficial to improve the thermal stability and luminous efficiency of the phosphor. After that, the outer shell is prepared through the reaction between H₂MF₆ with the base liquid A solution. This process enhances the moisture resistance and anti-deterioration capabilities of the phosphor, without affecting the luminous efficiency of the phosphor.

Preferably, in step (3), the adding the series of the BX solutions into the base liquid A solution in turn is adding the series of the BX solutions into the base liquid A solution in an order of increasing concentrations of the K₂MnF₆ in turn. In the present application, the series of the BX solutions are added in sequence according to the order of increasing concentration of K₂MnF₆ to obtain the inner core with an increasing trend of the atom percentages of the activator Mn⁴⁺ from the inside to the outside in the radial direction. This further enhances the absorption rate of the phosphor for the excitation light.

Preferably, in step (2), the taking the series of the K₂MnF₆ is taking the K₂MnF₆ with masses increasing in a form of an arithmetic sequence. Adopting raw materials of K₂MnF₆ with masses increasing in the form of the arithmetic sequence, in order to make the atom percentage of Mn⁴⁺ in the inner core prepared increase linearly and uniformly from the inside to the outside in the radial direction, which is beneficial to enhance the absorption effect and conversion efficiency of the phosphor for the excitation light. Optionally, a tolerance of mass increasing in the form of the arithmetic sequence is 0.1-0.3 g.

Preferably, a mass concentration of the H₂MF₆ solution is 10-15%, and mass of K₂MnF₆ used for each 5-7.5 g H₂MF₆ in the series of the BX solutions is 0-3 g.

Preferably, a mass concentration of the hydrofluoric acid solution is 35-55%; and in the base liquid A solution, a volume of the hydrofluoric acid solution used for each 15-25 g the salt of the A is 200-300 mL.

Preferably, in step (3), a total mass of the series of the BX solutions added is 100-1300 g; and mass of the H₂MF₆ solution added is 5-200 g in the adding the H₂MF₆ solution into the inner core mixed system.

Preferably, the series of the BX solutions and the H₂MF₆ solution are stirred at 10-50°C during the addition process. After the stirring, the supernatant is removed, and the remaining part is washed and dried.

Preferably, addition rates for the series of the BX solutions and the H₂MF₆ solution are 10-50 mL/s; and stirring times are 2-5 h.

Preferably, in the salt of the A, the A is a K element, that is, the salt of the A is a potassium salt. Optionally, the salt of the A is potassium hydrogen difluoride.

Furthermore, a mass concentration of the hydrofluoric acid solution is 40%-55%.

Preferably, in the H₂MF₆, the M is Si, and the H₂MF₆ solution is a H₂SiF₆ solution, that is, a fluorosilicic acid solution.

The third purpose of the present application is to provide any one of the above anti-deterioration red phosphors or the anti-deterioration red phosphor prepared by any one of the preparation methods applies to a field of an LCD backlight source or a field of LED lighting.

The fourth purpose of the present application is to provide an LCD backlight source, the LCD backlight source includes an excitation chip and a phosphor coated on the excitation chip; the phosphor is any one of the above anti-deterioration red phosphors; or, the phosphor is the anti-deterioration red phosphor prepared by any one of the above preparation methods.

The fifth purpose of the present application is to provide a lighting device, the lighting device includes a light emitting device; the light emitting device includes an excitation chip and a phosphor coated on the excitation chip; the phosphor is any one of the above anti-deterioration red phosphors; or, the phosphor is the anti-deterioration red phosphor prepared by any one of the above preparation methods.

### DESCRIPTION OF DRAWINGS

FIG. 1 is a distribution diagram of a relative content of Mn⁴⁺ along a radial direction in a particle of the anti-deterioration red phosphor.
FIG. 2 is a SEM diagram of particles of the phosphor before cutting in a specific implementation method, a left image is a top-view SEM image of the particles of the phosphor, and the right image is a 45° side-view SEM image of cutting particle of the phosphor revealing a fresh profile.
FIG. 3 is a location diagram for EDS point scanning analysis of a particle of the anti-deterioration red phosphor of Embodiment 1.
FIG. 4 is a location diagram for EDS line scanning analysis of a particle of the anti-deterioration red phosphor of Embodiment 5.
FIG.5 is an EDX line scan analysis result of the particles of the anti-deterioration red phosphor of Embodiment 5.

### DETAILED DESCRIPTION OF PREFERRED EMBODIMENTS

In order to make the purpose, technical scheme and advantages of the present application more clear, the following combined with the implementation examples, the present application is further described in detail. It should be understood that the following implementation method are only exemplary implementation methods used to illustrate the principle of the present application. That is, in the red phosphor A₂M₍₁₋ₓ₎F₆:xMn₄₊. Preferably, the A and the M prefer K and Si, respectively., and the synthetic raw materials prefer potassium hydrogen difluoride, fluosilicic acid and so on. However, the present application is not limited to this.

For the sake of simplicity, the present application only explicitly discloses some numerical ranges. However, any lower limit could be combined with any upper limit to form an unspecified range; and any lower limit could be combined with other lower limit to form an unspecified range. Similarly, any upper limit could be combined with any other upper limit to form an unspecified range. In addition, although not explicitly recorded, each point or single value between the range endpoints is included in the range, unless otherwise specified. Therefore, each point or single value could serve as its own lower or upper limit, and could be combined with any other point, single value, or other lower or upper limit to form an unspecified range.

Compared to the traditional red phosphors, K₂SiF₆:Mn⁴⁺ red phosphor has the advantage of high luminous efficiency, but its poor moisture resistance may readily cause performance degradation, thereby influencing its application effect in LED lighting. The red phosphor in the related art, while enhancing its moisture resistance, would inevitably suffer from a negative impact on its luminous efficiency. Therefore, there is an urgent need for a red phosphor that combines high moisture resistance with high luminous efficiency.

In order to solve the above problems, the present application provides an anti-deterioration red phosphor. the core-shell structure includes an inner core and an outer shell, the inner core and the outer shell are independently selected from substances shown in a chemical formula I; the chemical formula I: A₂M₍₁₋ₓ₎F₆:xMn⁴⁺. In the chemical formula I, the A includes at least one of Li, Na, K, Rb and Cs, and the M includes at least one of Si, Ge and Ti. An atom percentage of Mn⁴⁺ in an innermost layer of the inner core is a, the atom percentage of Mn⁴⁺ in an outermost layer of the inner core is b, and b>a. The atom percentage of Mn⁴⁺ in each place inside a particle of the inner core is x₁, and a value range of the x₁ is the a≤x₁≤b. The atom percentage of Mn⁴⁺ in the outer shell is x₂, and a value range of the x₂ is 0≤x₂≤0.1%.

For example, in the chemical formula I, 0<x≤0.05.

In some embodiments, the x₁ is in an increasing trend from the inside to the outside in a radial direction of the inner core. In the present application, the radial direction of the inner core from the inside to the outside, refers to a direction from an innermost layer of the inner core to a point on an outermost layer of the kernel closest to the innermost layer of the inner core. The innermost layer of the inner core is a first layer of the inner core, which is formed firstly in the preparation of the anti-deterioration red phosphor. That is, the first layer of the inner core is formed by a reaction between a base liquid A solution and a BX solution first added. In a particle of the phosphor of the present application, an innermost region of the inner core is a region with the lowest activator concentration.

In some specific embodiments, the inner core is divided into n layers from the inside to the outside along the radial direction, and the n is an integer and a value range of the n is 5≤n≤ 20. An atom percentage of Mn⁴⁺ in a same layer is the same, and the atom percentages of Mn⁴⁺ in different layers increase from the inside to the outside along the radial direction of the inner core.

In some specific embodiments, a lower limit of the n is selected from any one value in 5, 6, 7, 8, 9, 10, 11, 12, 13, 14, 15, 16, 17, 18 and 19, and an upper limit of the n is selected from any one value in 6, 7, 8, 9, 10, 11, 12, 13, 14, 15, 16, 17, 18, 19 and 20. A value range of the n is a range formed by any one value of the lower limit and any one value of the upper limit.

In some specific embodiments, the increasing trend is that the x₁ increases linearly or nonlinearly from the inside to the outside in the radial direction of the inner core.

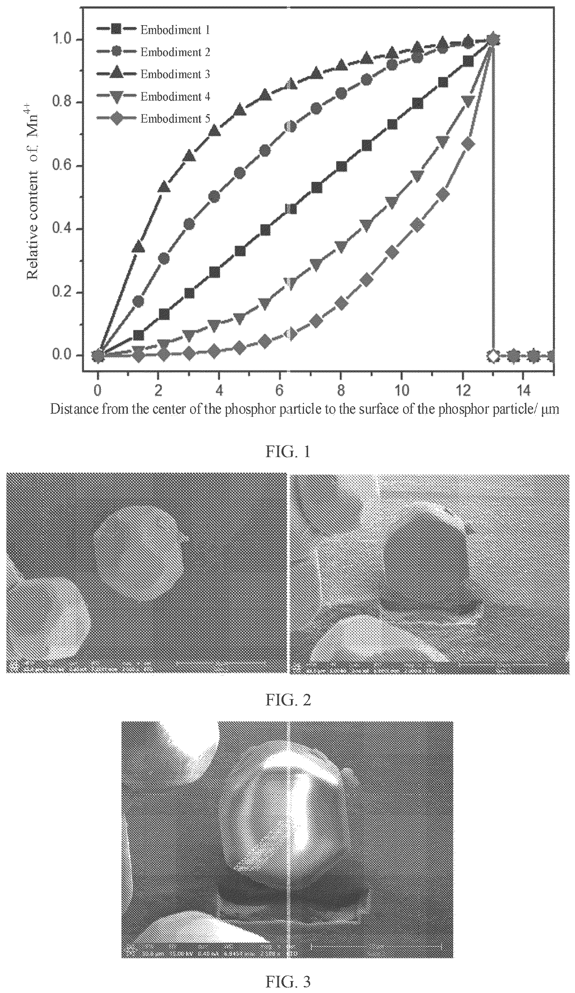

In some specific implementations, the increasing trend is that the x₁ increases linearly and uniformly from the inside to the outside in the radial direction of the inner core. In the present application, increasing linearly and uniformly means that the atom percentages of Mn⁴⁺ from the inside to the outside of the inner core maintain a same linear growth trend in the radial direction of the inner core. For example, FIG. 1 shows the increasing trend of a relative content of Mn⁴⁺ of Embodiment 1. That is, the increasing trend of the atom percentages of Mn⁴⁺ in any two adjacent layers of the inner core are the same.

The present application also provides a preparation method of the anti-deterioration red phosphor, for preparing any one of the above anti-deterioration red phosphors, and the preparation method includes following steps: (1) dissolving a salt of the A in a hydrofluoric acid solution, denoted as a base liquid A solution; (2) preparing a series of BX solutions with different concentrations of K₂MnF₆ by taking a series of the K₂MnF₆ and dissolving the series of the K₂MnF₆ in equal masses of H₂MF₆ solutions; and (3) adding the series of the BX solutions into the base liquid A solution in turn, controlling a concentration of the K₂MnF₆ in the BX solution added for a first time is the lowest, and controlling the concentration of K₂MnF₆ in the BX solution added for a last time is the highest, and obtaining an inner core mixed system to prepare the inner core; and adding the H₂MF₆ solution into the inner core mixed system to prepare the outer shell to obtain the anti-deterioration red phosphor. The salt of the A is selected from at least one of a fluoride, a hydrogen fluoride salt, a sulfate, a nitrate, a sulfuric acid hydrogen salt, a carbonate, and a bicarbonate of the A, and the A is selected from any one of Li, Na, K, Rb and Cs. Besides, in the K₂MF₆, the M is selected from any one of Si, Ge and Ti.

In some exemplary embodiments, fluoride of the A could be selected from any one of lithium fluoride, sodium fluoride, potassium fluoride, rubidium fluoride and cesium fluoride. The hydrogen fluoride salt of the A could be selected from any one of LiHF₂, NaHF₂, KHF₂, RbHF₂ and CsHF₂. Sulfate of the A could be selected from any one of Li₂SO₄, Na₂SO₄, K₂SO₄, Rb₂SO₄ and Cs₂SO₄. Nitrate of the A could be selected from any one of LiNO₃, NaNO₃, KNO₃, RbNO₃ and CsNO₃. Bisulfate of the A could be selected from any one of LiHSO₄, NaHSO₄, KHSO₄, RbHSO₄ and CsHSO₄. The carbonate of A could be selected from any one of Li₂CO₃, Na₂CO₃, K₂CO₃, Rb₂CO₃ and Cs₂CO₃. Bicarbonate of the A could be selected from any one of LiHCO₃, NaHCO₃, KHCO₃, RbHCO₃ and CsHCO₃.

In some exemplary embodiments, the H₂MF₆ could be selected from any of H₂SiF₆, H₂GeF₆ and H₂TiF₆.

In some embodiments, in step (3), the process of adding the series of the BX solutions into the base liquid A solution in turn is adding the series of the BX solutions into the base liquid A solution in an order of increasing concentrations of the K₂MnF₆ in turn.

In some specific embodiments, in step (2), the process of taking a series of the K₂MnF₆ is taking raw materials of the K₂MnF₆, whose masses are a₁, a₂, a₃,..., aₙ respectively. Values of a₁, a₂, a₃,..., aₙ are in an increasing trend in sequence, and the n is an integer with a range of 5≤n≤ 20.

In some specific embodiments, a range of the n is 10≤n≤20.

In some specific embodiments, taking and dissolving the raw materials of the K₂MnF₆ whose masses are a₁, a₂, a₃,..., aₙ into the H₂MF₆ solution respectively, in order to prepare the series of the BX solutions with increasing concentrations of K₂MnF₆, denoted as BX₁, BX₂, BX₃, ..., BXₙ in sequence. The concentrations of K₂MnF₆ in the BX₁, BX₂, BX₃, ..., BXₙ solutions are in an increasing trend in sequence.

In some specific embodiments, a value range of the a₁ is 0≤a₁≤0.01 g. When the a₁ is 0, it means that the masses of K₂MnF₆ increases from 0, and the concentration of K₂MnF₆ of the BX₁ solution in the series of BX solutions prepared is 0.

In some specific embodiments, the process of adding the series of the BX solutions into the base liquid A solution in turn in an increasing order of the concentrations is adding the the BX₁-BXₙ solutions into the base liquid A solution in sequence. The inner core is prepared through a series of reactions that occur in turn. The inner core is divided into n layers from the inside to the outside along the radial direction. Each time the BX solution is added, it reacts with the base liquid A solution to form a layer of the inner core.

In some specific embodiments, in step (3), the mass of H₂MF₆ in the BX solution added each time is the same as the mass of H₂MF₆ in the H₂MF₆ solution. The number of times for adding H₂MF₆ solution to the inner core mixed system is 1-5 times.

In some specific embodiments, a value range of the aₙ is 2.5 g≤aₙ≤3 g.

In some specific embodiments, a mass concentration of the H₂MF₆ solution is 10-15%. The mass of the H₂MF₆ solution is 40-60 g. For example, the mass of the H₂MF₆ solution is 50 g.

In some specific embodiments, mass of the salt of the A is 15-25 g.

In some specific embodiments, a mass concentration of the hydrofluoric acid solution is 35-55%; and a volume of the hydrofluoric acid solution is 200-300 mL. For example, the volume of the hydrofluoric acid solution is 250 mL.

In some specific embodiments, the process of the washing involves sequentially adding an aqueous solution of HF and anhydrous ethanol, followed by stirring and washing. Besides, a mass concentration of the aqueous solution of HF is 3-10%.

In some specific embodiments, the process of the drying is drying performed at 50-70°C.

### Embodiments

In the following, the technical solutions of the present application are explained in combination with the specific embodiments. The raw materials used in the following embodiments are all from ordinary commercially available products, and the devices or equipment used are all purchased from conventional market sales channels.

### Embodiment 1

In the present embodiment, the anti-deterioration red phosphor includes a core-shell structure, the core-shell structure includes an inner core and an outer shell, the inner core and the outer shell are independently selected from substances shown in a chemical formula I; the chemical formula I: K₂Si₍₁₋ₓ₎F₆:xMn⁴⁺. The atom percentage of Mn⁴⁺ in each place inside a particle of the inner core is x₁. The x₁ increases linearly and uniformly from the inside to the outside in the radial direction of the inner core, and a value range of the x₁ is 0≤x₁≤0.77%. Besides, the atom percentage of Mn⁴⁺ in the outer shell is x₂, and a value range of the x₂ is 0≤x₂≤0.1%. What's more, an average particle size of the anti-deterioration red phosphor in the present embodiment is 30 µm, where an average thickness of the outer shell is 1.8 µm.

The preparation method for the anti-deterioration red phosphor in the present embodiment includes the following steps:
(1) dissolving 21 g KHF₂ in 250 mL hydrofluoric acid solution with a mass fraction of 40%, then preparing a base liquid A solution;
(2) taking a series of the K₂MnF₆, dissolving the series of the K₂MnF₆ in 50 g fluorosilicic acid solution with a mass fraction of 10% according to an order of masses increasing respectively, and preparing a series of BX solutions with increasing concentration of the K₂MnF₆; and
(3) adding the series of the BX solutions to the base liquid A solution according to an order of concentrations increasing, and obtaining an inner core mixed system for preparing the inner core, wherein adding times are recorded as A₁, A₂, A₃,..., A₁₆; then adding 50 g of fluorosilicic acid solution with a mass fraction of 10% to the inner core mixed system for three times in sequence, in order to prepare an outer shell ( masses of the K₂MnF₆ raw materials contained in A1-A19 is shown in Table 1), where adding times are recorded as A₁₇, A₁₈ and A₁₉. During the adding process, stirring the series of the BX solutions and the fluorosilicic acid solution at 40°C, pouring out supernatant after stirring for 2 h, adding a HF aqueous solution with a mass fraction of 5% for stirring and washing twice, then washing twice with anhydrous ethanol, and drying at 60°C under a blast drying condition to obtain the anti-deterioration red phosphor for the present application.

### Embodiment 2

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in each place inside a particle of the inner core is x₁. The x₁ increases from the inside to the outside in the radial direction of the inner core, and a value range of the x₁ is the 0≤x₁≤0.80%. The atom percentage of Mn⁴⁺ in the outer shell is x₂, and a value range of the x₂ is 0≤x₂≤0.01%. What's more, an average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2), K₂MnF₆ raw materials with masses increasing are taken to prepare the series of the BX solutions, and in step (3), masses of the K₂MnF₆ raw materials contained in the added series of the BX solutions are shown in the Table 1.

### Embodiment 3

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in each place inside a particle of the inner core is x₁. The x₁ increases from the inside to the outside in the radial direction of the inner core, and a value range of the x₁ is 0≤x₁≤0.82%. The atom percentage of Mn⁴⁺ in the outer shell is x₂, and a value range of the x₂ is 0≤x₂≤0.02%. What's more, an average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2), K₂MnF₆ raw materials with masses increasing are taken to prepare the series of the BX solutions, and in step (3), masses of the K₂MnF₆ raw materials contained in the series of the BX solutions added are shown in the Table 1.

### Embodiment 4

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in each place inside a particle of the inner core is x₁. The x₁ increases from the inside to the outside in the radial direction of the inner core, and a value range of the x₁ is 0≤x₁≤0.79%. The atom percentage of Mn⁴⁺ in the outer shell is x₂, and a value range of the x₂ is 0≤x₂≤0.01%. What's more, an average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2), K₂MnF₆ raw materials with masses increasing are taken to prepare the series of the BX solutions, and in step (3), masses of the K₂MnF₆ raw materials contained in the series of the BX solutions added are shown in the Table 1.

### Embodiment 5

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in each place inside a particle of the inner core is x₁. The x₁ increases from the inside to the outside in the radial direction of the inner core, and a value range of the x₁ is the 0≤x₁≤0.81%. The atom percentage of Mn⁴⁺ in the outer shell is x₂, and a value range of the x₂ is 0≤x₂≤0.02%. What's more, an average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2), K₂MnF₆ raw materials with masses increasing are taken to prepare the series of the BX solutions, and in step (3), masses of the K₂MnF₆ raw materials contained in the series of the BX solutions added are shown in the Table 1.

### Embodiment 6

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in an innermost layer of the inner core of the phosphor is 0, the atom percentage of Mn⁴⁺ in an outermost layer of the inner core of the phosphor is 0.77%, and the atom percentage of Mn⁴⁺ in each place of the the inner core of the phosphor is x₁. Besides, in addition to the innermost layer and the outermost layer of the inner core, the x₁ is randomly distributed from the inside to the outside in the radial direction of the inner core, and a value range of the x₁ is 0≤x₁≤0.77%. Besides, the atom percentage of Mn⁴⁺ in the outer shell is x₂, and a value range of the x₂ is 0≤x₂≤0.01%. What's more, an average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2), K₂MnF₆ raw materials are taken to prepare the series of the BX solutions, and in step (3), masses of the K₂MnF₆ raw materials contained in the series of the BX solutions added are shown in the Table 1.

### Embodiment 7

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in an innermost layer of the inner core of the phosphor is 0, the atom percentage of Mn⁴⁺ in an outermost layer of the inner core of the phosphor is 5%, and the atom percentage of Mn⁴⁺ in each place of the the inner core of the phosphor is x₁. The x₁ increases linearly and uniformly from the inside to the outside in the radial direction of the inner core, and a value range of the x₁ is the 0≤x₁≤5%; and the atom percentage of Mn⁴⁺ in the outer shell is x₂, and a value range of the x₂ is 0≤x₂≤0.1%.

### Embodiment 8

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in an innermost layer of the inner core of the phosphor is 0.1%, and the atom percentage of Mn⁴⁺ in an outermost layer of the inner core of the phosphor is 0.3%. The atom percentage of Mn⁴⁺ in each place of the the inner core of the phosphor is xᵢ, the x₁ increases linearly and uniformly from the inside to the outside in the radial direction of the inner core, and a value range of the x₁ is the 0.1%≤x₁≤0.3%. The atom percentage of Mn⁴⁺ in the outer shell is x₂, and a value range of the x₂ is 0≤x₂≤0.01%.

### Embodiment 9

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in an innermost layer of the inner core of the phosphor is 0, the atom percentage of Mn⁴⁺ in an outermost layer of the inner core of the phosphor is 2%, and the atom percentage of Mn⁴⁺ in each place of the inner core of the phosphor is x₁. The x₁ increases linearly and uniformly from the inside to the outside in the radial direction of the inner core, and a value range of the x₁ is the 0≤x₁≤2%. The atom percentage of Mn⁴⁺ in the outer shell is x₂, and a value range of the x₂ is 0≤x₂≤0.05%.

### Embodiment 10

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Si₍₁₋ₓ₎F₆:xMn⁴⁺, where the atom percentage of Mn⁴⁺ in an innermost layer of the inner core of the phosphor is 0, the atom percentage of Mn⁴⁺ in an outermost layer of the inner core of the phosphor is 0.5%, and the atom percentage of Mn⁴⁺ in each place of the inner core of the phosphor is x₁. The x₁ increases linearly and uniformly from the inside to the outside in the radial direction of the inner core, and a value range of the x₁ is 0≤x₁≤0.5%. The atom percentage of Mn⁴⁺ in the outer shell is x₂, and a value range of the x₂ is 0≤x₂≤0.01%.

### Embodiment 11

In the present embodiment, the anti-deterioration red phosphor includes a core-shell structure, the core-shell structure includes an inner core and an outer shell, the inner core and the outer shell are independently selected from substances shown in a chemical formula I. The chemical formula I: Li₂Si₍₁₋ₓ₎F₆:xMn⁴⁺, where the atom percentage of Mn⁴⁺ in each place inside a particle of the inner core is x₁, the x₁ increases linearly and uniformly from the inside to the outside in the radial direction of the inner core, and a value range of the x₁ is the 0≤x₁≤0.81%; and the atom percentage of Mn⁴⁺ in the outer shell is x₂, and a value range of the x₂ is 0≤x₂≤0.01%. An average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (1), Li₂CO₃ is used as a substitute for KHF₂ to dissolve into the hydrofluoric acid solution.

### Embodiment 12

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: Cs₂Si₍₁₋ₓ₎F₆:xMn⁴⁺, where the atom percentage of Mn⁴⁺ in each place inside a particle of the inner core is x₁, the x₁ increases linearly and uniformly from the inside to the outside in the radial direction of the inner core, and a value range of the x₁ is 0≤x₁≤0.80%. The atom percentage of Mn⁴⁺ in the outer shell is x₂, and a value range of the x₂ is 0≤x₂≤0.01%. What's more, an average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (1), CsF is used a substitute for KHF₂ to dissolve into the hydrofluoric acid solution.

### Embodiment 13

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Ge₍₁₋ₓ₎F₆:xMn⁴⁺, where the atom percentage of Mn⁴⁺ in each place inside a particle of the inner core is x₁, the x₁ increases linearly and uniformly from the inside to the outside in the radial direction of the inner core, and a value range of the x₁ is the 0≤x₁≤0.82%. The atom percentage of Mn⁴⁺ in the outer shell is x₂, and a value range of the x₂ is 0≤x₂≤0.01%. An average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2) and step (3), a H₂GeF₆ solution is used a substitute for the fluorosilicic acid solution.

### Embodiment 14

In the present embodiment, the anti-deterioration red phosphor includes a core-shell structure, the core-shell structure includes an inner core and an outer shell, and the inner core and the outer shell are independently selected from substances shown in a chemical formula I. The chemical formula I: K₂Ti₍₁₋ₓ₎F₆:xMn⁴⁺, where the atom percentage of Mn⁴⁺ in each place inside a particle of the inner core is x₁, the x₁ increases linearly and uniformly from the inside to the outside in the radial direction of the inner core, and a value range of the x₁ is the 0≤x₁≤0.81%. The atom percentage of Mn⁴⁺ in the outer shell is x₂, and a value range of the x₂ is 0≤x₂≤0.01%. An average particle size of the anti-deterioration red phosphor in the present embodiment is 30 µm, where an average thickness of the outer shell is 1.8 µm.

The preparation method of the anti-deterioration red phosphor in this embodiment differs from that in the Embodiment 1 only in that: in step (2) and step (3), a H₂TiF₆ solution is used as a substitute for the fluorosilicic acid solution.

### Comparison 1

The phosphor in this comparison differs from that in the Embodiment 1 only in that: the present comparison only includes the inner core of the anti-deterioration red phosphor from the Embodiment 1, excluding its outer shell.

The preparation method of the phosphor in this comparison differs from that in the Embodiment 6 is only in that: in step (3), adding the series of the BX solutions to the base liquid A solution in an order of concentrations increasing, where adding times are recorded as A₁, A₂, A₃,..., A₁₆, and the masses of the K₂MnF₆ raw materials contained in A₁-A₁₆ are shown in table 1 below, which is identical to the masses of the K₂MnF₆ raw materials corresponding to A₁-A₁₆ in step (3) of the Embodiment 1. After adding the BX solution, the fluorosilicic acid solution is no longer added.

### Comparison 2

The phosphor in this comparison differs from that in the Embodiment 1 only in that: the atom percentage of Mn⁴⁺ at each place within the particle in the inner core of the phosphor is x₁, and the x₁ exhibits a uniform distribution from the inside to the outside in the radial direction.

The preparation method of the phosphor in this comparison differs from that in the Embodiment 1 is only in that: in step (2), a series of the BX solutions with the same concentration of the K₂MnF₆ are prepared by respectively dissolving 16 equal parts of the K₂MnF₆ raw materials into 50 g of 10% fluosilicic acid solution, with each part containing 1.35 g of K₂MnF₆; and in step (3), the series of the BX solutions are added to the base liquid A solution, and the adding times are recorded as A₁, A₂, A₃,..., A₁₆, These additions are used to prepare an inner core with a uniform distribution of the atom percentage of Mn⁴⁺. The preparation of the outer shell is the same as that in the Embodiment 1.

### Comparison 3

The phosphor in this comparison differs from that in the Comparison 2 only in that: the present comparison only includes the inner core of the phosphor from the Comparison 2, excluding its outer shell..

The preparation method of the phosphor in this comparison differs from that in the Comparison 2 is only in that:: in step (3), after adding the series of the BX solutions to the base liquid A solution, the fluorosilicic acid solution is no longer added.

Table 1 shows the masses of the K₂MnF₆ in the series of the BX solutions and the fluosilicic acid solution added during step (3) of the Comparison 1 and the Embodiments 1-6.

**Table 1**

| Adding time | Embodiment 1 | Embodiment 2 | Embodiment 3 | Embodiment 4 | Embodiment 5 | Embodiment 6 | Comparison 1 |
|---|---|---|---|---|---|---|---|
| A1 | 0 | 0 | 0 | 0 | 0 | 0 | 0 |
| A2 | 0.18 | 0.03 | 0.02 | 0.52 | 0.89 | 1.44 | 0.18 |
| A3 | 0.36 | 0.07 | 0.04 | 0.86 | 1.32 | 2.34 | 0.36 |
| A4 | 0.54 | 0.15 | 0.08 | 1.16 | 1.58 | 1.62 | 0.54 |
| A5 | 0.72 | 0.22 | 0.12 | 1.38 | 1.81 | 1.26 | 0.72 |
| A6 | 0.90 | 0.34 | 0.17 | 1.57 | 2.05 | 0.36 | 0.90 |
| A7 | 1.08 | 0.46 | 0.23 | 1.76 | 2.25 | 0.72 | 1.08 |
| A8 | 1.26 | 0.59 | 0.30 | 1.91 | 2.40 | 1.08 | 1.26 |
| A9 | 1.44 | 0.74 | 0.39 | 2.07 | 2.51 | 1.80 | 1.44 |
| A10 | 1.62 | 0.95 | 0.48 | 2.24 | 2.58 | 2.16 | 1.62 |
| A11 | 1.80 | 1.14 | 0.61 | 2.37 | 2.63 | 1.98 | 1.80 |
| A12 | 1.98 | 1.34 | 0.79 | 2.43 | 2.66 | 0.18 | 1.98 |
| A13 | 2.16 | 1.57 | 1.00 | 2.52 | 2.68 | 2.52 | 2.16 |
| A14 | 2.34 | 1.87 | 1.27 | 2.60 | 2.68 | 0.90 | 2.34 |
| A15 | 2.52 | 2.23 | 1.77 | 2.65 | 2.69 | 0.54 | 2.52 |
| A16 | 2.70 | 2.70 | 2.70 | 2.70 | 2.70 | 2.70 | 2.70 |
| A17 | 0 | 0 | 0 | 0 | 0 | 0 | / |
| A18 | 0 | 0 | 0 | 0 | 0 | 0 | / |
| A19 | 0 | 0 | 0 | 0 | 0 | 0 | / |

From the Table 1, it could be seen that the Embodiments 1-5 prepare the series of BX solutions using the K₂MnF₆ raw materials with a gradually increasing trend in masses for the preparation for the inner core. The masses of the K₂MnF₆ raw materials used in the preparation of the inner core in the Embodiment 1 are increased in a form of an arithmetic progression, and the tolerance is 0.18 g. The increasing trend of the Embodiments 2-5 is non-linear. In the preparation of the inner core, only the masses of K₂MnF₆ raw materials contained in the BX solutions, added both initially and finally, are controlled to be a minimum of 0 g and a maximum of 2.70 g, respectively. For the remaining adding times, the masses of K₂MnF₆ raw material are arranged randomly. The mass of the K₂MnF₆ raw material used to prepare the inner core of the Comparison 1 is the same as that of the Embodiment 1, but the outer shell is not prepared.

### Test embodiment 1

Focused ion beam scanning electron microscope (FIB-SEM) equipment is used to cut the anti-deterioration red phosphor of the Embodiment 1-5 by dual ion beam. EDS energy spectrum analysis is performed from the body center to the surface on the fresh surface. Taking the Embodiment 1 as an example, FIG. 2 is a SEM diagram of particles of the phosphor before cutting in a specific implementation method, a left image is a top-view SEM image of the particles of the phosphor, and the right image is a 45° side-view SEM image of cutting particle of the phosphor revealing a fresh profile. FIG. 3 is a location diagram for EDS point scanning analysis of a particle of the anti-deterioration red phosphor of Embodiment 1. The radial distribution of the percentage of Mn atoms in the particle of the anti-deterioration red phosphor from the innermost layer of the inner core to the outermost layer of the outer shell, obtained by EDS energy spectrum is shown in Table 2.

**Table 2: Radial distribution of Mn atom percentage in the Embodiments 1 to 5**

| Atom percentage% | Embodiment 1 | Embodiment 2 | Embodiment 3 | Embodiment 4 | Embodiment 5 |
|---|---|---|---|---|---|
| | 0.00 | 0.00 | 0.00 | 0.00 | 0.00 |
| | 0.04 | 0.01 | 0.01 | 0.15 | 0.23 |
| | 0.10 | 0.04 | 0.01 | 0.26 | 0.38 |
| | 0.19 | 0.05 | 0.03 | 0.37 | 0.48 |
| | 0.22 | 0.07 | 0.05 | 0.41 | 0.53 |
| | 0.25 | 0.11 | 0.05 | 0.48 | 0.61 |
| | 0.32 | 0.15 | 0.06 | 0.52 | 0.64 |
| | 0.37 | 0.17 | 0.08 | 0.56 | 0.71 |
| | 0.46 | 0.22 | 0.13 | 0.63 | 0.74 |
| Ato% | 0.44 | 0.27 | 0.16 | 0.67 | 0.75 |
| | 0.53 | 0.34 | 0.18 | 0.72 | 0.79 |
| | 0.62 | 0.42 | 0.24 | 0.75 | 0.79 |
| | 0.67 | 0.47 | 0.31 | 0.75 | 0.80 |
| | 0.65 | 0.58 | 0.37 | 0.74 | 0.81 |
| | 0.73 | 0.65 | 0.53 | 0.77 | 0.80 |
| | 0.77 | 0.80 | 0.82 | 0.79 | 0.81 |
| | 0.01 | 0.01 | 0.01 | 0.01 | 0.01 |
| | 0.01 | 0.00 | 0.02 | 0.00 | 0.01 |
| | 0.00 | 0.00 | 0.00 | 0.01 | 0.02 |

Based on the Table 2, the anti-deterioration red phosphor from each of Embodiments 1-5 is radially divided into 16 layers from the innermost part to the outermost part of the inner core, while the outer shell is radially divided into 3 layers from the inside out. The percentage of Mn atoms exhibits an increasing trend radially from the innermost layer to the outermost layer of the inner core. Despite some individual values being equal to or slightly lower than previous ones, this does not affect the overall increasing trend of Mn atom percentage along the radial direction of the inner core. Notably, the innermost layer of the inner core does not contain Mn atom, with a Mn atom percentage of 0%, and Mn atom percentage at the outermost layer of the inner core is 0.77%-0.82%. In the outer shell, Mn atom percentage is between 0% and 0.02%. Among them, Mn atom percentage in Embodiment 1 shows an overall linear and uniform increase along the radial direction of the inner core.

To visually reflect the increasing trend of Mn content in Embodiments 1-5, a schematic diagram of the radial distribution of relative content of Mn⁴⁺ within the particle of the anti-deterioration red phosphor for each of Embodiments 1-5 is shown in FIG. 1. In FIG. 1, the content at the outermost layer of the inner core in each embodiment is considered as the standard and is denoted as 1.0. The solid points on the image indicate the relative content of Mn⁴⁺ at different positions along the radial direction within the particle of the phosphor, and the hollow points indicate positions where data is not available. As seen in FIG. 1, the particles of the anti-deterioration red phosphor for the Embodiments 1-5 do not contain Mn⁴⁺ at their internal centers. As one moves away from the center and approaches the outermost layer of the inner core, the relative content of Mn⁴⁺ exhibits an increasing trend. Among them, the relative content of Mn⁴⁺ in the Embodiment 1 shows a linear and uniform increase. The relative content of Mn⁴⁺ in the particle of the phosphor in each of the Embodiments 1-5 reaches its maximum at the outermost layer of the inner core, and then gradually approaches or reaches 0 in the outer shell.

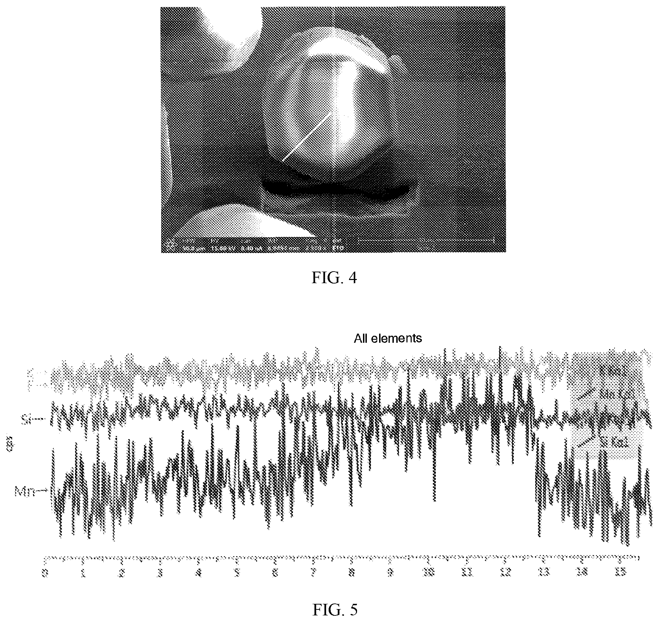

The surface of the particle of the phosphor is tested by EDX from the body center to the surface using the focused ion beam scanning electron microscope (FIB-SEM) equipment. The surface of the particle of the phosphor is the surface corresponding to the particle of the anti-deterioration red phosphor after cutting in the Embodiment 5. The EDX line scan positions are illustrated in FIG. 4, and the results of the EDX line scan analysis are shown in FIG. 5. From the line scan result diaphragm, it could be observed that the content of Mn in the particle of the anti-deterioration red phosphor exhibits a gradient increase trend from the innermost layer to the outermost layer of the inner core, while in the outer shell, the content of Mn of the activator demonstrates a sharp decrease trend.

### Test embodiment 2

Aging tests are performed on the phosphors in the Embodiments 1-6 and Comparisons 1-3, measuring the luminous flux of each embodiment or comparison at 0, 250, 500, 750, and 1000 hours, respectively. Table 3 presents the test methods and equipment used for the 1000-hour aging test in the present application. Table 4 displays the aging test data for the KSF phosphors prepared in the embodiments and comparisons. ( Note: KSF-0 represents the sample from the Comparison 1, KSF-1 represents the sample from the Embodiment 1, KSF-2 represents the sample from the Embodiment 2, KSF-3 represents the sample from the Embodiment 3, KSF-4 represents the sample from the Embodiment 4, KSF-5 represents the sample from the Embodiment 5, KSF-6 represents the sample from the Embodiment 6, KSF-7 represents the sample from Comparison 2, and KSF-8 represents the sample from Comparison 3).

**Table 3: test methods and equipments of the Embodiments 1-6 and aging test of Comparisons 1-3.**

| Model number | Manufacture scheme | Bracket type | Chip | Current | Ageing conditioning | Test machine |
|---|---|---|---|---|---|---|
| KSF-X (X= 0, 1, 2, 3, 4, 5, 6, 7, 8) | Positive white color temperature full spectrum | SMD-2835 | 22*25mil Double wafer parallel connection | 65 mA | Temperature: 85°C | EVERFINE HAAS2000 |
| | | | | | Humidity: 85RH% | |

**Table 4: the results of luminous flux and brightness ratio in the Embodiments 1-6 and Comparisons 1-3 during the aging tests.**

| Parameter | Testing time ( h ) | | | | |
|---|---|---|---|---|---|
| | 0 | 250 | 500 | 750 | 1000 |
| KSF-0 Luminous flux(lm) | 128.35 | 127.58 | 126.93 | 125.14 | 123.47 |
| KSF-0 Brightness ratio(%) | 100% | 99.4% | 98.9% | 97.5% | 96.2% |
| KSF-1 Luminous flux(lm) | 128.21 | 127.95 | 127.44 | 125.18 | 127.05 |
| KSF-1 Brightness ratio(%) | 100% | 99.8% | 99.4% | 99.2% | 99.2% |
| KSF-2 Luminous flux(lm) | 128.15 | 127.89 | 127.50 | 127.12 | 126.86 |
| KSF-2 Brightness ratio(%) | 100% | 99.8% | 99.5% | 99.2% | 99.0% |
| KSF-3 Luminous flux(lm) | 128.17 | 128.04 | 127.40 | 127.27 | 127.01 |
| KSF-3 Brightness ratio(%) | 100% | 99.9% | 99.4% | 99.3% | 99.1% |
| KSF-4 Luminous flux(lm) | 128.02 | 127.37 | 126.99 | 126.86 | 126.61 |
| KSF-4 Brightness ratio(%) | 100% | 99.5% | 99.2% | 99.1% | 98.9% |
| KSF-5 Luminous flux(lm) | 128.14 | 127.37 | 127.11 | 126.98 | 126.85 |
| KSF-5 Brightness ratio(%) | 100% | 99.4% | 99.2% | 99.1% | 99.0% |
| KSF-6 Luminous flux(lm) | 126.34 | 125.97 | 125.47 | 125.22 | 125.10 |
| KSF-6 Brightness ratio(%) | 100% | 99.7% | 99.3% | 99.1% | 99.0% |
| KSF-7 Luminous flux(lm) | 117.48 | 117.13 | 116.89 | 116.66 | 116.07 |
| KSF-7 Brightness ratio(%) | 100% | 99.7% | 99.5% | 99.3% | 98.8% |
| KSF-8 Luminous flux(lm) | 120.83 | 119.98 | 119.14 | 117.57 | 116.12 |
| KSF-8 Brightness ratio(%) | 100% | 99.3% | 98.6% | 97.3% | 96.1% |

As shown in Table 4, the LED devices fabricated using the phosphors from the Embodiments 1-6 and the Comparison 1, under conditions of 85°C and 85% RH, exhibit an initial luminous flux ranging from 126.34 lm to 128.35 lm. In contrast, the LED device using the phosphor from the Comparison 2 has an initial luminous flux of only 117.48 lm, while the corresponding Comparison 3 used for comparison, has an initial luminous flux of 120.83 lm. This indicates that the inner core of the Comparison 2 experiences a 2.8% reduction in initial luminous flux after the outer shell added. It is evident that the present application, by controlling the content of Mn in the innermost and outermost layers of the core, and employing an outer shell with a relatively low atom percentage of Mn, does not compromise the luminescent efficiency of the phosphor. Besides, this is conducive to maintaining a high luminescent intensity of the phosphor. As the testing time increases, the luminous flux of the LED device using the phosphor from the Comparison 1 gradually decreases, with a reduction in brightness ratio of approximately 1% every 250 hours. After 1000 hours, the luminous flux drops to only 123.47 lm, and the brightness is only 96.2% of the initial brightness, representing a decrease of 3.8% compared to the initial value. In contrast, the LED devices corresponding to the anti-deterioration red phosphors from the Embodiments 1-6 exhibit a smaller decrease in the luminous flux. After 1,000 hours of testing with a high-temperature and high-humidity environment, the luminous flux remains within a range of 125.10 lm to 127.05 lm, and the brightness still reaches 98.9%-99.2% of the initial brightness, basically maintaining a brightness ratio of 99%. It is evident that by setting an outer shell with very little or no Mn⁴⁺ content to coat the inner core of the phosphor in the present application, the moisture resistance and anti-deterioration ability of the phosphor are significantly enhanced without compromising its luminescent efficiency. Besides, this enables the phosphor to maintain a high luminescent intensity even when operated in harsh environments with long-term exposure to a high temperatures and high humidity.

Furthermore, a horizontal comparison among the Embodiments 1 - 5 reveals that the Embodiment 1, which adopts a solution where the atomic percentage of Mn increases linearly and uniformly along the radial direction of the inner core, exhibits the highest measured initial luminous flux of 128.21 lm. Additionally, during the aging test, the Embodiment 1 demonstrates the lowest reduction in luminous flux, with the brightness ratio remaining at 99.2% after 1000 hours, a mere decrease of 1.8%. This indicates that, in the present application, by controlling Mn atom percentage to increase linearly and uniformly along the radial direction of the inner core, the conversion efficiency of the phosphor is ensured. When paired with the outer shell, it experiences minimal impact on its luminous flux from a harsh environment during long-term service, which is conducive to further ensuring a higher luminous efficiency.

### Test embodiment 3

The phosphor samples from the Embodiments 1, 7 to 10 are encapsulated into the LED chip using the method described in Table 3 of the Test embodiment 2, and the luminous flux of each embodiment sample is tested. The results are shown in Table 5 below.

**Table 5: luminous flux results of Samples from the Embodiment 1 and the Embodiments 7-10**

| Embodiment number | Embodiment 1 | Embodiment 7 | Embodiment 8 | Embodiment 9 | Embodiment 10 |
|---|---|---|---|---|---|
| Luminous flux(lm) | 128.21 | 119.35 | 120.73 | 124.20 | 126.86 |

As shown in the Table 5, the luminous flux of the phosphor samples from the Embodiment 1 and the Embodiments 7-10 ranges from 119.35 to 128.21 lm, demonstrating strong luminescent performance. Among them, the phosphor samples from the Embodiments 1, 9, and 10, which have a difference in activator atom percentage between the outermost and innermost layers of the inner core ranging from 0.5% to 2%, exhibit a luminous flux of 124.20 to 128.21 lm. This is a further improvement compared to the Embodiments 7 and 8. It is evident that by controlling the distribution of Mn⁴⁺ atom percentage within the inner core in the present application, the absorption efficiency of the phosphor is enhanced, leading to more excellent luminescent performance.

The above description is merely a specific embodiment of the present application.

## Claims

1. An anti-deterioration red phosphor, wherein the anti-deterioration red phosphor comprises a core-shell structure, the core-shell structure comprises an inner core and an outer shell, the inner core and the outer shell are independently selected from substances shown in a chemical formula I;
A₂M₍₁₋ₓ₎F₆ : xMn⁴⁺ the chemical formula I;
in the chemical formula I, the A comprises at least one of Li, Na, K, Rb and Cs, and the M comprises at least one of Si, Ge and Ti;
wherein, an atom percentage of Mn⁴⁺ in an innermost layer of the inner core is a, and an atom percentage of Mn⁴⁺ in an outermost layer of the inner core is b, and b>a; and the atom percentage of Mn⁴⁺ in each place inside a particle of the inner core is x₁, and a value range of the x₁ is a≤x₁≤b; and
the atom percentage of Mn⁴⁺ in the outer shell is x₂, and a value range of the x₂ is 0≤x₂≤0.1%.

2. The anti-deterioration red phosphor of claim 1, wherein the x₁ is in an increasing trend from an inside to an outside in a radial direction of the inner core.

3. The anti-deterioration red phosphor of claim 2, wherein the increasing trend is that the x₁ increases linearly and uniformly from the inside to the outside in the radial direction of the inner core.

4. The anti-deterioration red phosphor of claim 1, wherein, in the inner core, a value range of the a is 0≤a≤0.1%, and a value range of the b is 0.3%≤b≤5%.

5. The anti-deterioration red phosphor of claim 4, wherein, in the inner core, the value range of the a is 0≤a≤0.01%, and the value range of the b is 0.5%≤b≤1.5%.

6. The anti-deterioration red phosphor of claim 1, wherein, in the phosphor, b>x₂.

7. The anti-deterioration red phosphor of claim 1, wherein, in the phosphor, 0≤x₂/b≤1/10.

8. The anti-deterioration red phosphor of claim 1, wherein, an average particle size of the anti-deterioration red phosphor is 5 - 40 µm; and an average thickness of the outer shell is 0.1-2 µm.

9. A preparation method for the anti-deterioration red phosphor of any one of claims 1 to 8, wherein the preparation method comprises following steps:
(1) dissolving a salt of the A in a hydrofluoric acid solution, denoted as a base liquid A solution;
(2) preparing a series of BX solutions with different concentrations of K₂MnF₆ by taking a series of the K₂MnF₆ and dissolving the series of the K₂MnF₆ in equal masses of H₂MF₆ solutions; and
(3) adding the series of the BX solutions into the base liquid A solution in turn, controlling a concentration of the K₂MnF₆ in the BX solution added for a first time is the lowest, controlling the concentration of K₂MnF₆ in the BX solution added for a last time is the highest, obtaining an inner core mixed system to prepare the inner core, and adding the H₂MF₆ solution into the inner core mixed system to prepare the outer shell to obtain the anti-deterioration red phosphor;
wherein, the salt of the A is selected from at least one of a fluoride, a hydrogen fluoride salt, a sulfate, a nitrate, a sulfuric acid hydrogen salt, a carbonate, and a bicarbonate of the A, and the A is selected from any one of Li, Na, K, Rb and Cs; and in the K₂MF₆, the M is selected from any one of Si, Ge and Ti.

10. The preparation method for the anti-deterioration red phosphor of claim 9, wherein, in step (3), the adding the series of the BX solutions into the base liquid A solution in turn is adding the series of the BX solutions into the base liquid A solution in an order of increasing concentrations of the K₂MnF₆ in turn;
preferably, in step (2), the taking the series of the K₂MnF₆ is taking the K₂MnF₆ with masses increasing in a form of an arithmetic sequence.

11. The preparation method for the anti-deterioration red phosphor of claim 9, wherein, a mass concentration of the H₂MF₆ solution is 10-15%, and mass of K₂MnF₆ used for each 5 g H₂MF₆ in the series of the BX solutions is 0-3 g; and
a mass concentration of the hydrofluoric acid solution is 35-55%; and in the base liquid A solution, a volume of the hydrofluoric acid solution used for each 15-25 g the salt of the A is 200-300 mL.

12. The preparation method for the anti-deterioration red phosphor of claim 9, wherein, in step (3), mass of the series of the BX solutions added is 100-1300 g; and mass of the H₂MF₆ solution added is 5-200 g in the adding the H₂MF₆ solution into the inner core mixed system.

13. The anti-deterioration red phosphor of any one of claims 1 to 8 or the anti-deterioration red phosphor prepared by the preparation method of any one of claims 9 to 12 applies to a field of an LCD backlight source or a field of LED lighting.

14. An LCD backlight source, wherein, the LCD backlight source comprises an excitation chip and a phosphor coated on the excitation chip;
the phosphor is the anti-deterioration red phosphor of any one of claims 1 to 8; or,
the phosphor is the anti-deterioration red phosphor prepared by the preparation method of any one of claims 9 to 12.

15. A lighting device, wherein, the lighting device comprises a light emitting device;
the light emitting device comprises an excitation chip and a phosphor coated on the excitation chip;
the phosphor is the anti-deterioration red phosphor of any one of claims 1 to 8; or,
the phosphor is the anti-deterioration red phosphor prepared by the preparation method of any one of claims 9 to 12.

## Patentansprüche

1. Alterungsbeständiger roter Leuchtstoff, wobei der alterungsbeständige rote Leuchtstoff eine Kern-Hülle-Struktur umfasst, wobei die Kern-Hülle-Struktur einen inneren Kern und eine äußere Hülle umfasst, wobei der innere Kern und die äußere Hülle unabhängig voneinander aus Substanzen ausgewählt sind, die in einer chemischen Formel I dargestellt sind;
A₂M₍₁₋ₓ₎F₆ : xMn⁴⁺ die chemische Formel I;
wobei in der chemischen Formel I A mindestens eines von Li, Na, K, Rb und Cs umfasst und M mindestens eines von Si, Ge und Ti umfasst;
wobei ein Atomprozentsatz von Mn⁴⁺ in einer innersten Schicht des inneren Kerns a beträgt und der Atomprozentsatz von Mn⁴⁺ in einer äußersten Schicht des inneren Kerns b beträgt, und b > a; und der Atomprozentsatz von Mn⁴⁺ an jeder Stelle innerhalb eines Partikels des inneren Kerns x₁ ist, und ein Wertebereich von x₁ a ≤ x₁ ≤ b ist; und
der Atomprozentsatz von Mn⁴⁺ in der äußeren Hülle x₂ ist, und ein Wertebereich von x₂ 0 ≤ x₂ ≤ 0,1 % ist.

2. Alterungsbeständiger roter Leuchtstoff gemäß Anspruch 1, wobei x₁ in radialer Richtung des inneren Kerns von innen nach außen ansteigt.

3. Alterungsbeständiger roter Leuchtstoff gemäß Anspruch 2, wobei der Anstieg darin besteht, dass x₁ in radialer Richtung des inneren Kerns von innen nach außen linear und gleichmäßig zunimmt.

4. Alterungsbeständiger roter Leuchtstoff gemäß Anspruch 1, wobei im inneren Kern ein Wertebereich von a 0 ≤ a ≤ 0,1 % beträgt und ein Wertebereich von b 0,3 % ≤ b ≤ 5 % beträgt.

5. Alterungsbeständiger roter Leuchtstoff gemäß Anspruch 4, wobei im inneren Kern der Wertebereich von a 0 ≤ a ≤ 0,01 % beträgt und der Wertebereich von b 0,5 % ≤ b ≤ 1,5 % beträgt.

6. Alterungsbeständiger roter Leuchtstoff gemäß Anspruch 1, wobei im Leuchtstoff gilt: b > x₂.

7. Alterungsbeständiger roter Leuchtstoff gemäß Anspruch 1, wobei im Leuchtstoff gilt: 0 ≤ x₂/b ≤ 1/10.

8. Alterungsbeständiger roter Leuchtstoff gemäß Anspruch 1, wobei eine durchschnittliche Partikelgröße des alterungsbeständigen roten Leuchtstoffs 5-40 µm beträgt und die durchschnittliche Dicke der Außenhülle 0,1-2 µm beträgt.

9. Verfahren zur Herstellung des alterungsbeständigen roten Leuchtstoffs gemäß einem der Ansprüche 1 bis 8, wobei das Herstellungsverfahren die folgenden Schritte umfasst:
(1) Auflösen eines Salzes von A in einer Flusssäurelösung, bezeichnet als Basislösung A;
(2) Herstellen einer Reihe von BX-Lösungen mit unterschiedlichen Konzentrationen an K₂MnF₆, indem eine Reihe von K₂MnF₆ genommen und die Reihe von K₂MnF₆ in gleichen Massen an H₂MF₆-Lösungen gelöst wird; und
(3) nacheinander Hinzufügen der Reihe von BX-Lösungen zur Basislösung A, wobei die Konzentration von K₂MnF₆ in der zuerst zugegebenen BX-Lösung am niedrigsten ist, die Konzentration von K₂MnF₆ in der zuletzt zugegebenen BX-Lösung am höchsten ist, ein Mischsystem für den inneren Kern zur Herstellung des inneren Kerns erhalten wird und die H₂MF₆-Lösung in das Mischsystem für den inneren Kern gegeben wird, um die äußere Hülle herzustellen und den altersbeständigen roten Leuchtstoff zu erhalten;
wobei das Salz von A aus mindestens einem der folgenden ausgewählt ist: einem Fluorid, einem Fluorwasserstoffsalz, einem Sulfat, einem Nitrat, einem Schwefelsäure-Wasserstoffsalz, einem Carbonat und einem Bicarbonat von A, und A aus einem beliebigen von Li, Na, K, Rb und Cs ausgewählt ist; und in K₂MF₆ M aus einem beliebigen von Si, Ge und Ti ausgewählt ist.

10. Verfahren zur Herstellung des alterungsbeständigen roten Leuchtstoffs gemäß Anspruch 9, wobei in Schritt (3) das nacheinander Hinzufügen der Reihe von BX-Lösungen zur Basislösung A darin besteht, die Reihe von BX-Lösungen in der Reihenfolge steigender Konzentrationen von K₂MnF₆ nacheinander zur Basislösung A hinzuzufügen;
vorzugsweise in Schritt (2) die Entnahme der Reihe von K₂MnF₆ die Entnahme von K₂MnF₆ mit in Form einer arithmetischen Folge ansteigenden Massen ist.

11. Verfahren zur Herstellung des alterungsbeständigen roten Leuchtstoffs gemäß Anspruch 9, wobei die Massenkonzentration der H₂MF₆-Lösung 10-15 % beträgt und die Masse an K₂MnF₆, die pro 5 g H₂MF₆ in der Reihe der BX-Lösungen verwendet wird, 0-3 g beträgt; und
die Massenkonzentration der Flusssäurelösung 35-55 % beträgt; und in der Basislösung A ein Volumen der Fluorwasserstoffsäurelösung, das pro 15-25 g des Salzes A verwendet wird, 200-300 ml beträgt.

12. Verfahren zur Herstellung des alterungsbeständigen roten Leuchtstoffs gemäß Anspruch 9, wobei in Schritt (3) die Masse der hinzugefügten Reihe von BX-Lösungen 100-1300 g beträgt; und die Masse der hinzugefügten H₂MF₆-Lösung 5-200 g beträgt, wenn die H₂MF₆-Lösung in das Mischsystem des inneren Kerns gegeben wird.

13. Alterungsbeständiger roter Leuchtstoff gemäß einem der Ansprüche 1 bis 8 oder der durch das Herstellungsverfahren gemäß einem der Ansprüche 9 bis 12 hergestellte alterungsbeständige rote Leuchtstoff findet Anwendung im Bereich einer LCD-Hintergrundbeleuchtungsquelle oder im Bereich von LED-Beleuchtung.

14. LCD-Hintergrundbeleuchtung, wobei die LCD-Hintergrundbeleuchtung einen Anregungschip und einen auf den Anregungschip aufgebrachten Leuchtstoff umfasst;
der Leuchtstoff der altersbeständige rote Leuchtstoff gemäß einem der Ansprüche 1 bis 8 ist; oder
der Leuchtstoff der altersbeständige rote Leuchtstoff, der nach dem Herstellungsverfahren gemäß einem der Ansprüche 9 bis 12 hergestellt wurde, ist.

15. Beleuchtungsvorrichtung, wobei die Beleuchtungsvorrichtung eine lichtemittierende Vorrichtung umfasst;
die lichtemittierende Vorrichtung einen Anregungschip und einen auf den Anregungschip aufgetragenen Leuchtstoff umfasst;
der Leuchtstoff der alterungsbeständige rote Leuchtstoff gemäß einem der Ansprüche 1 bis 8 ist; oder
der Leuchtstoff der alterungsbeständige rote Leuchtstoff ist, der nach dem Herstellungsverfahren gemäß einem der Ansprüche 9 bis 12 hergestellt wurde.

## Revendications

1. Phosphore rouge anti-détérioration, dans lequel le phosphore rouge anti-détérioration comprend une structure cœur-écorce, la structure cœur-écorce comprend un cœur interne et une écorce externe, le cœur interne et l'écorce externe étant indépendamment sélectionnés parmi les substances indiquées dans une formule chimique I ;
A₂M₍₁₋ₓ₎F₆ : xMn⁴⁺ la formule chimique I ;
dans la formule chimique I, A comprend au moins un élément parmi Li, Na, K, Rb et Cs, et M comprend au moins un élément parmi Si, Ge et Ti ;
dans lequel, un pourcentage atomique de Mn⁴⁺ dans une couche la plus interne du cœur interne est a, et un pourcentage atomique de Mn⁴⁺ dans une couche la plus externe du cœur interne est b, et b>a ; et le pourcentage atomique de Mn⁴⁺ en chaque point à l'intérieur d'une particule du cœur interne est x₁, et une plage de valeurs de x₁ est a≤x₁≤b ; et
le pourcentage atomique de Mn⁴⁺ dans l'écorce externe est x₂, et une plage de valeurs de x₂ est 0≤x₂≤0,1 %.

2. Phosphore rouge anti-détérioration selon la revendication 1, dans lequel x₁ décrit une tendance croissante de l'intérieur vers l'extérieur dans une direction radiale du cœur interne.

3. Phosphore rouge anti-détérioration selon la revendication 2, dans lequel la tendance croissante est que x₁ augmente linéairement et uniformément de l'intérieur vers l'extérieur dans la direction radiale du cœur interne.

4. Phosphore rouge anti-détérioration selon la revendication 1, dans lequel, dans le cœur interne, une plage de valeurs de a est 0≤a≤0,1 %, et une plage de valeurs de b est 0,3 %≤b≤5 %.

5. Phosphore rouge anti-détérioration selon la revendication 4, dans lequel, dans le cœur interne, la plage de valeurs de a est 0≤a≤0,01 %, et la plage de valeurs de b est 0,5 %≤b≤1,5 %.

6. Phosphore rouge anti-détérioration selon la revendication 1, dans lequel, dans le phosphore, b>x₂.

7. Phosphore rouge anti-détérioration selon la revendication 1, dans lequel, dans le phosphore, 0 ≤ x₂/b≤1/10.

8. Phosphore rouge anti-détérioration selon la revendication 1, dans lequel une taille moyenne des particules du phosphore rouge anti-détérioration est de 5-40 µm ; et une épaisseur moyenne de l'écorce externe est de 0,1-2 µm.

9. Procédé de préparation du phosphore rouge anti-détérioration selon l'une quelconque des revendications 1 à 8, dans lequel le procédé de préparation comprend les étapes suivantes :
(1) la dissolution d'un sel de A dans une solution d'acide fluorhydrique, appelée solution liquide de base A ;
(2) la préparation d'une série de solutions BX de différentes concentrations de K₂MnF₆ en prélevant une série du K₂MnF₆ et en dissolvant la série du K₂MnF₆ en masses égales de solutions H₂MF₆ ; et
(3) l'ajout successif de la série de solutions BX à la solution liquide de base A, la régulation de la concentration de K₂MnF₆ dans la solution BX ajoutée la première fois est la plus faible, la régulation de la concentration de K₂MnF₆ dans la solution BX ajoutée la dernière fois est la plus élevée, l'obtention d'un système mixte de cœur interne pour préparer le cœur interne, et l'ajout de la solution H₂MF₆ au système mixte de cœur interne pour préparer l'écorce externe afin d'obtenir le phosphore rouge anti-détérioration ;
dans lequel le sel de A est au moins un élément sélectionné parmi un fluorure, un sel de fluorure d'hydrogène, un sulfate, un nitrate, un sel d'hydrogène d'acide sulfurique, un carbonate et un bicarbonate de A, et A est un quelconque élément sélectionné parmi Li, Na, K, Rb et Cs ; et dans K₂MF₆, M est un quelconque élément sélectionné parmi Si, Ge et Ti.

10. Procédé de préparation du phosphore rouge anti-détérioration selon la revendication 9, dans lequel, à l'étape (3), l'ajout de la série de solutions BX dans la solution liquide de base A consiste à ajouter successivement la série de solutions BX dans la solution liquide de base A, dans un ordre de concentrations croissantes de K₂MnF₆ ;
de préférence, à l'étape (2), le prélèvement de la série de K₂MnF₆ consiste à prélever le K₂MnF₆ avec des masses croissantes suivant une suite arithmétique.

11. Procédé de préparation du phosphore rouge anti-détérioration selon la revendication 9, dans lequel une concentration massique de la solution H₂MF₆ est 10-15 %, et la masse de K₂MnF₆ utilisée tous les 5 g de H₂MF₆ dans la série de solutions BX est de 0-3 g ; et
une concentration massique de la solution d'acide fluorhydrique est 35-55 % ; et dans la solution liquide de base A, un volume de la solution d'acide fluorhydrique utilisé tous les 15-25 g du sel de A est de 200-300 ml.

12. Procédé de préparation du phosphore rouge anti-détérioration selon la revendication 9, dans lequel, à l'étape (3), la masse de la série de solutions BX ajoutées est de 100-1 300 g ; et la masse de la solution H₂MF₆ ajoutée est de 5-200 g lors de l'ajout de la solution H₂MF₆ au système mixte de cœur interne.

13. Phosphore rouge anti-détérioration selon l'une quelconque des revendications 1 à 8 ou phosphore rouge anti-détérioration préparé selon le procédé de préparation de l'une quelconque des revendications 9 à 12 s'applique à un champ d'une source de rétroéclairage LCD ou à un champ d'éclairage LED.

14. Source de rétroéclairage LCD, dans laquelle la source de rétroéclairage LCD comprend une puce d'excitation et un phosphore déposé sur la puce d'excitation ;
le phosphore est le phosphore rouge anti-détérioration selon l'une quelconque des revendications 1 à 8 ; ou,
le phosphore est le phosphore rouge anti-détérioration préparé selon le procédé de préparation selon l'une quelconque des revendications 9 à 12.

15. Dispositif d'éclairage, dans lequel le dispositif d'éclairage comprend un dispositif d'émission de lumière ;
le dispositif d'émission de lumière comprend une puce d'excitation et un phosphore déposé sur la puce d'excitation ;
le phosphore est le phosphore rouge anti-détérioration selon l'une quelconque des revendications 1 à 8 ; ou,
le phosphore est le phosphore rouge anti-détérioration préparé selon le procédé de préparation selon l'une quelconque des revendications 9 à 12.
